# EUROPEAN PATENT APPLICATION

(11) **EP 4 636 314 A1**
(43) Date of publication of application: **22.10.2025**
(21) Application number: 25170383.1
(22) Date of filing: 14.04.2025
(51) Int. Cl.: F24C 7/08, D06F 34/32, F25D 29/00, G06F 3/041, H03K 17/96

(54) **USER INTERFACE DEVICE FOR A HOUSEHOLD APPLIANCE AND HOUSEHOLD APPLIANCE COMPRISING SAID DEVICE**

(30) Priority: 15.04.2024 IT 202400008440
(71) Applicant: SMEG S.p.A., 42016 Guastalla (RE) (IT)
(72) Inventor: DALL'OGLIO, Alberto, 42016 GUASTALLA (RE) (IT); MASTILOVIC, Nebojsa, 42016 GUASTALLA (RE) (IT); FORNACCIARI, Matteo, 42016 GUASTALLA (RE) (IT)
(74) Representative: Studio Torta S.p.A.

(57) **Abstract**

A user interface device for a household appliance has a frame (3); a transparent cover screen (4) fixed to the frame (3); a housing (5) provided with a rear wall (6); a display panel (7), which is housed in the housing (5) and is provided with a light source (8) configured to generate graphical images and with a touch sensor (9) configured to detect a touch or a swipe on the cover screen (4); and a push assembly (10; 27) provided with a support element (11; 28) fixed to the frame (3) and a plurality of push elements (12; 29), which are arranged between the support element (11; 28) and the rear wall (6) of the housing (5) and are configured to push against the rear wall (6) so as to press the display panel (7) against the cover screen (4).

## Description

### CROSS-REFERENCE TO RELATED APPLICATIONS

This patent application claims priority from Italian patent application no. 102024000008440 filed on April 15, 2024, the entire disclosure of which is incorporated herein by reference.

### TECHNICAL FIELD

The present invention relates to a user interface device for a household appliance and to a household appliance comprising said device.

In particular, the present invention relates to a user interface device for an oven for cooking food, typically used in domestic kitchens or in the field of catering.

### STATE OF THE ART

As is known, household appliances are typically provided with a user interface which allows displaying the operating status of the household appliance and allows setting the operating parameters of the household appliance. By way of example, in the case of an oven for cooking food, the user interface generally allows displaying and setting cooking parameters, such as the temperature inside the oven and/or the cooking time and/or the cooking mode.

In recent decades, technological developments in the field of touch sensors have led to the installation of touch user interface devices in household appliances. Generally, said user interface devices comprise a transparent cover screen typically made of glass or plastic, and a display panel, which is arranged behind the cover screen, in contact with the cover screen, and is provided with a light source configured to generate graphical images and a touch sensor configured to detect a touch or a swipe on the cover screen.

To achieve a correct assembly of the known user interface devices, the display panel must be perfectly adherent to the cover screen. Generally, to ensure such adherence, the display panel is glued to the cover screen using optical bonding techniques.

As is known, optical bonding techniques involve the use of an optical adhesive to glue the cover screen to the upper surface of the display panel. This technique allows eliminating the air space between the cover screen and the display panel, ensuring adequate adhesion of the display panel to the cover screen and improving the performance of the user interface device in terms of sensitivity, uniformity and light contrast.

Furthermore, with the optical bonding technique it is possible to prevent dust and any liquid from coming into contact with the display panel and avoid the formation of condensation between the various layers of the display panel, especially in environments with high temperature fluctuations or variable humidity.

However, the assembly of the user interface devices by means of the known optical bonding techniques is complex and expensive. In particular, said assembly must be carried out in special environments, typically in clean rooms, and requires dedicated equipment and specialized operators.

### SUBJECT MATTER OF THE INVENTION

An object of the present invention is to manufacture a user interface device for a household appliance which mitigates the drawbacks of the prior art highlighted herein.

In accordance with the present invention, a user interface device for a household appliance is manufactured, the user interface device comprising:
- a frame;
- a transparent cover screen fixed to the frame;
- a housing provided with a rear wall;
- a display panel, which is housed in the housing, is arranged between the rear wall and the cover screen, and is provided with a light source configured to generate graphical images and with a touch sensor configured to detect a touch or a swipe on the cover screen; and
- a push assembly provided with a support element fixed to the frame and/or to the cover screen and a plurality of push elements, which are arranged between the support element and the rear wall of the housing and are configured to push against the rear wall so as to press the display panel against the cover screen.

Thanks to the present invention, it is possible to achieve optimal adhesion of the display panel on the cover screen without employing optical bonding techniques. In this manner, the assembly of the user interface device is simple and economical, and does not require the use of special environments, dedicated equipment and specialized operators.

Furthermore, thanks to the push assembly it is possible to modulate the thrust applied to different portions of the display panel so as to adequately control the pressure applied by the display panel against the cover screen.

In particular, the user interface device comprises an electronic control board, which is in communication with the display panel and is arranged between the support element of the push assembly and the rear wall of the housing.

In more detail, the electronic control board is provided with a plurality of through openings; each push element extending through a respective through opening of the electronic control board.

In this manner, each push element exerts a thrust directly against the rear wall of the housing passing through the through openings of the electronic board, without applying any pressure on the electronic board.

Furthermore, the through openings of the electronic board allow a correct centring of the housing with respect to the push assembly.

In particular, the electronic control board comprises at least one coupling notch; the housing comprising at least one engagement connector configured to couple with the at least one coupling notch so as to support the electronic control board.

In this manner, it is possible to couple the electronic control board to the housing and centre the electronic control board with respect to the housing in a simple and reliable manner.

In particular, the push assembly comprises a plurality of connection elements, which couple jointly the support element to the frame and/or to the cover screen, preferably said connection elements being arranged at respective ends of the support element.

In this manner, it is possible to jointly couple the push assembly to the frame and/or to the cover screen.

In accordance with a first embodiment, each push element is coupled to the support element so as to allow the adjustment of the thrust exerted by the push element on the rear wall of the housing.

In particular, the support element comprises a plurality of threaded openings; each push element comprising a threaded pin configured to be screwed within a respective threaded opening.

In practice, by screwing and/or unscrewing each threaded pin in/from the respective threaded opening, it is possible to easily adjust the thrust exerted by each push element on the rear wall of the housing.

Since each threaded pin can be screwed/unscrewed independently of the other push elements, it is possible to precisely modulate the distribution of the pressure exerted by the display panel on the cover screen, so as to ensure optimal adhesion of the display panel on the cover screen.

In accordance with a second embodiment, each push element comprises an elastic body configured to apply an elastic return force between the support element and the rear wall of the housing.

In practice, by selecting the rigidity of each elastic body it is possible to modulate the thrust applied by each push element on the housing. In this manner, it is possible to apply thrusts of different magnitudes at different portions of the housing.

In particular, each push element comprises a cylindrical body, which extends along a longitudinal axis and is fixed to the support element, and a sliding body, which is arranged in contact with the rear wall of the housing and is slidingly coupled to the cylindrical body along the longitudinal axis; the elastic body being interposed between the cylindrical body and the sliding body so as to determine an elastic return force directed along the longitudinal axis.

In this manner, it is possible to direct the thrust of each push element along the longitudinal axis, i.e., along a direction substantially perpendicular with respect to the rear wall of the housing.

A further object of the present invention is to manufacture a household appliance which mitigates the drawbacks of the known art.

In accordance with the present invention, a household appliance is manufactured comprising the user interface device as previously described.

### BRIEF DESCRIPTION OF THE FIGURES

Further characteristics and advantages of the present invention will be evident from the following description of a non-limiting example embodiment thereof, with reference to the figures of the accompanying drawings, wherein:
- Figure 1 is a front view, with parts removed for clarity and with schematic parts, of a household appliance manufactured in accordance with the present invention;
- Figure 2 is a section view, with parts removed for clarity, of a user interface device of the household appliance of Figure 1 manufactured in accordance with a first embodiment of the present invention;
- Figures 3 and 4 are further section views along respective section planes of the user interface device of Figure 2;
- Figure 5 is a rear view, with parts removed for clarity, of the user interface device of Figure 2;
- Figure 6 is an enlarged section view, with parts removed for clarity, of a detail of the user interface device of Figure 2;
- Figure 7 is a section view, with parts removed for clarity, of a user interface device of the household appliance of Figure 1 manufactured in accordance with a second embodiment of the present invention; and
- Figure 8 is an enlarged section view, with parts removed for clarity, of a detail of the user interface device of Figure 7.

### DETAILED DESCRIPTION OF THE FIGURES

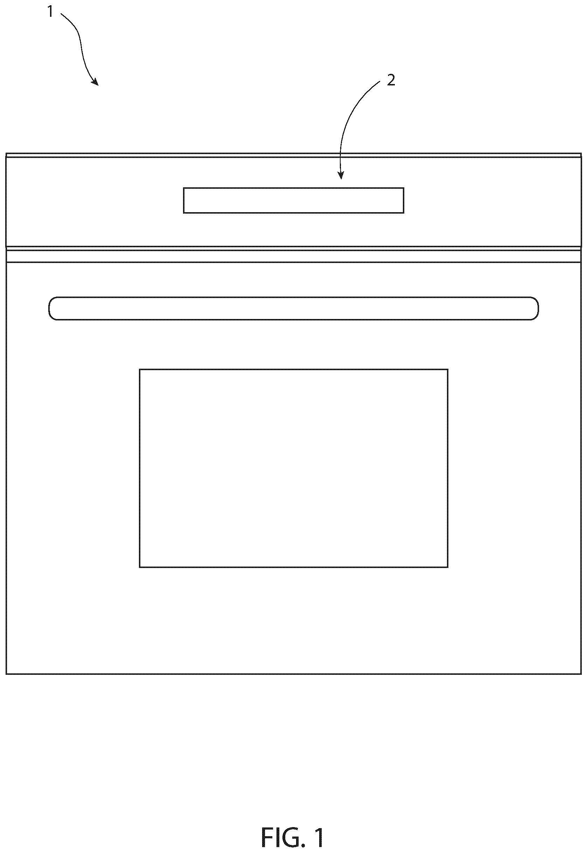

With reference to Figure 1, reference numeral 1 indicates, as a whole, a household appliance comprising a user interface device 2.

In the non-limiting case of the present invention described and illustrated herein, the household appliance 1 is an oven for cooking food, typically used in domestic kitchens or in the field of catering, without thereby limiting the wide range of possible applications of the present invention.

It is understood that the user interface device 2 can be installed on any further type of household appliance.

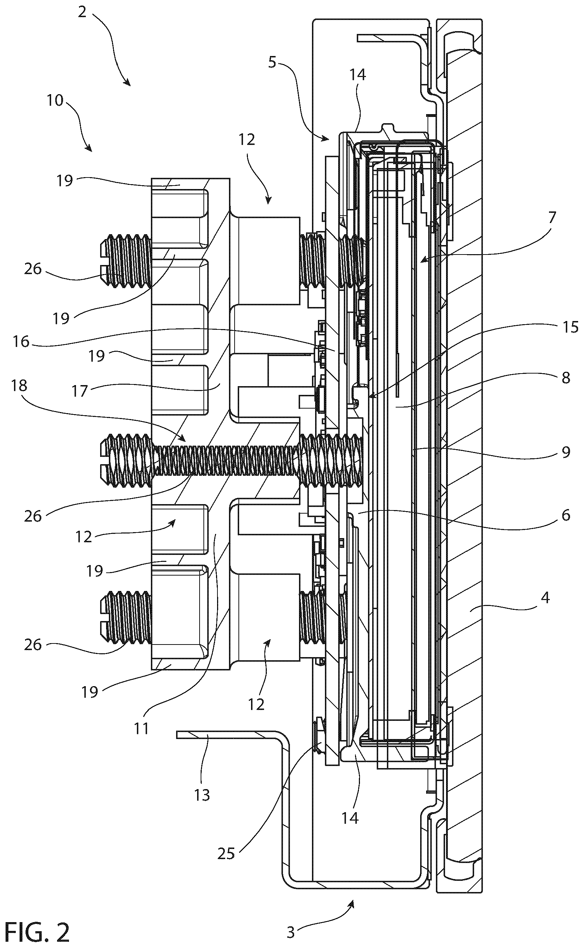

With reference to Figure 2, the user interface device 2 comprises a frame 3; a transparent cover screen 4 fixed to the frame 3; a housing 5 provided with a rear wall 6; a display panel 7, which is housed in the housing 5, is arranged between the rear wall 6 and the cover screen 4, and is provided with a light source 8 configured to generate graphical images and with a touch sensor 9 configured to detect a touch or a swipe on the cover screen 4; and a push assembly 10 provided with a support element 11 fixed to the frame 3 and/or to the cover screen 4 and with a plurality of push elements 12, which are arranged between the support element 11 and the rear wall 6 of the housing 5 and are configured to push against the rear wall 6 so as to press the display panel 7 against the cover screen 4.

In practice, the user interface device 2 is of the touch-screen type. In particular, the light source 8 comprises a layer of the Thin Film Transistor (TFT) type and the touch sensor 9 is of the resistive or capacitive type.

The frame 3 is configured to be mounted on a support of the household appliance 1 (Figure 1) and, in particular, comprises a coupling portion 13 configured to be fixed to said support of the household appliance 1 (Figure 1).

In more detail, the cover screen 4 is made of glass or a polymeric material and allows the passage of light. In accordance with a non-limiting embodiment of the present invention, the cover screen 4 is flattened and has a quadrangular shape.

In accordance with the present invention, the rear wall 6 of the housing 5 extends substantially parallel to the cover screen 4, at a distance from the outer screen 4.

In more detail, the housing 5 comprises a plurality of lateral walls 14, which delimit together with the rear wall 6 a housing space for the display panel 7. In practice, the housing 5 defines a protective casing for the display panel 7.

In accordance with an embodiment, the rear wall 6 of the housing 5 comprises a plurality of shaped portions 15, each of which is configured to house an end portion of a respective push element 12.

Furthermore, the user interface device 2 comprises an electronic control board 16, which is in communication with the display panel 7 and is arranged between the support element 11 and the rear wall 6 of the housing 5.

In practice, the electronic control board 16 is configured to control the generation of graphical images by means of the light source 8 as a function of touches/swipes on the cover screen 4 detected by the touch sensor 9.

In particular, the support element 11 of the push assembly 10 extends substantially parallel with respect to the cover screen 4, at a distance from the rear wall 6 of the housing 5.

In the case described and illustrated herein, the support element 11 comprises a flat wall 17 provided with a plurality of openings 18, each of which is engaged by a respective push element 12. Furthermore, the support element 11 comprises a plurality of reinforcement walls 19, each of which is integral with the flat wall 17 and extends transversely with respect to the flat wall 17.

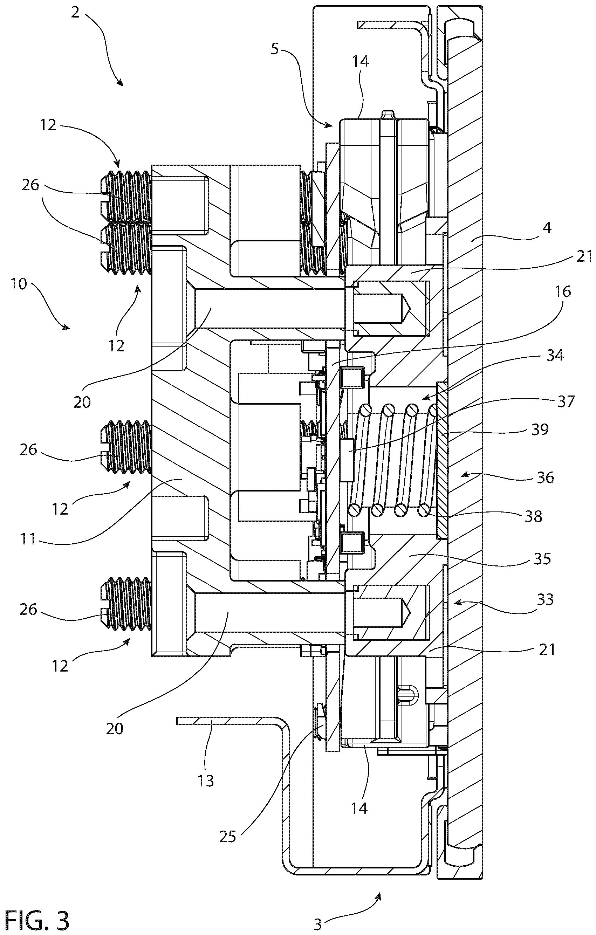

With reference to Figure 3, the push assembly 10 comprises a plurality of connection elements 20, which couple jointly the support element 11 to the frame 3. In particular, the connection elements 20 are arranged at respective ends of the support element 11.

In more detail, the frame 3 comprises two bases 33 (only one of which is visible in Figure 3), each of which is coupled jointly to the cover screen 4, preferably by gluing, and comprises a plurality of housing seats 21 for housing the respective connection elements 20. In practice, the bases 33 jointly couple the support element 11 to the cover screen 4 so as to centre the support element 11 with respect to the cover screen 4.

Furthermore, each base 33 comprises a housing seat 34 delimited by an annular wall 35. The interface device 2 comprises a touch button 36 provided with a light element 37, for example a light emitting diode, which is configured to emit light, is installed on the electronic control board 16 at the housing seat 34, and is facing the cover screen 4; and an elastic element 38, for example a helical spring, which is housed inside the housing seat 34 and is interposed between the cover screen 4 and the electronic control board 16.

In particular, the touch button 36 comprises a graphical element 39, which is arranged on the cover screen 4 inside the housing seat 34 and is aligned with respect to the light element 37 and the elastic element 38.

From the operational point of view, the housing seat 34 and the elastic element 38 carry out the function of guiding the light emitted by the light element 37 towards the graphical element 38 arranged on the cover screen 4.

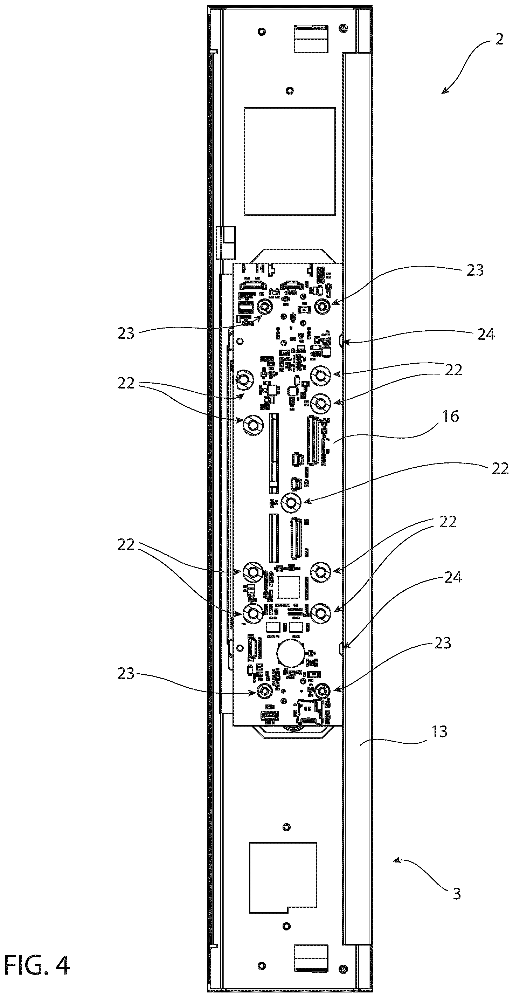

With reference to Figure 4, the electronic control board 16 is provided with a plurality of through openings 22, each of which is engaged by a respective push element 12 extending through said through opening 22, and a plurality of through openings 23, each of which is engaged by a respective connection element 20 extending through said through opening 23.

Furthermore, the electronic control board 16 has two coupling notches 24, in particular obtained along a lower edge of the electronic control board 16. The housing 5 comprises two engagement connectors 25 (Figures 2 and 3), each of which is configured to couple with a respective coupling notch 24 so as to support the electronic control board 16.

In particular, the coupling notches 24 allow the electronic control board 16 to be centred with respect to the housing 5 so as to align the through openings 22 with the respective push elements 12 and to align the through openings 23 with the respective connection elements 20.

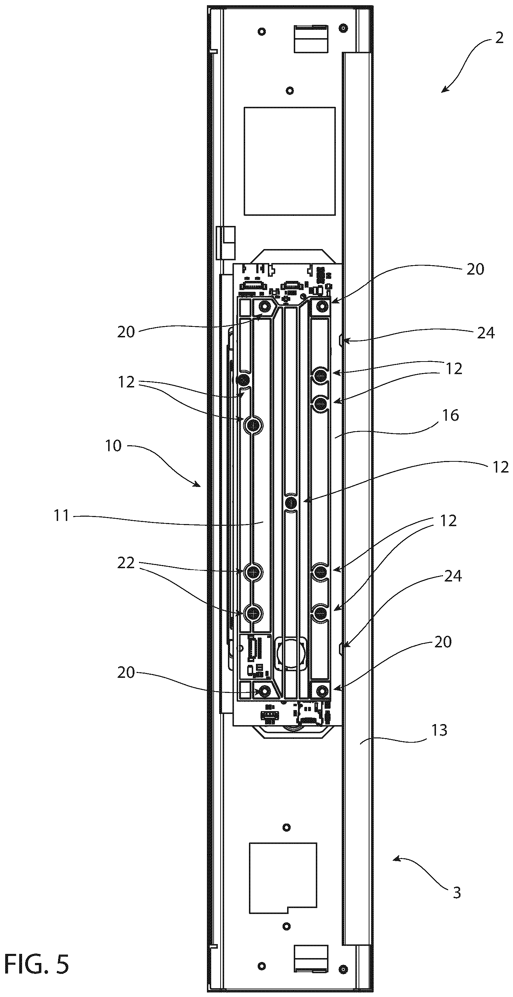

With reference to Figure 5, the push assembly 10 comprises nine push elements 12 distributed along the support element 11.

It is understood that the number and arrangement of the push elements 12 can vary depending on the particular operating applications of the user interface device 2. By way of example, the number and arrangement of the push elements 12 can vary as a function of the size of the display panel 7.

In the non-limiting case of the present invention described and illustrated herein, one of the push elements 12 is arranged at a central portion of the support element 11 and, in particular, the further push elements 12 are arranged at respective angular portions of the display panel 7.

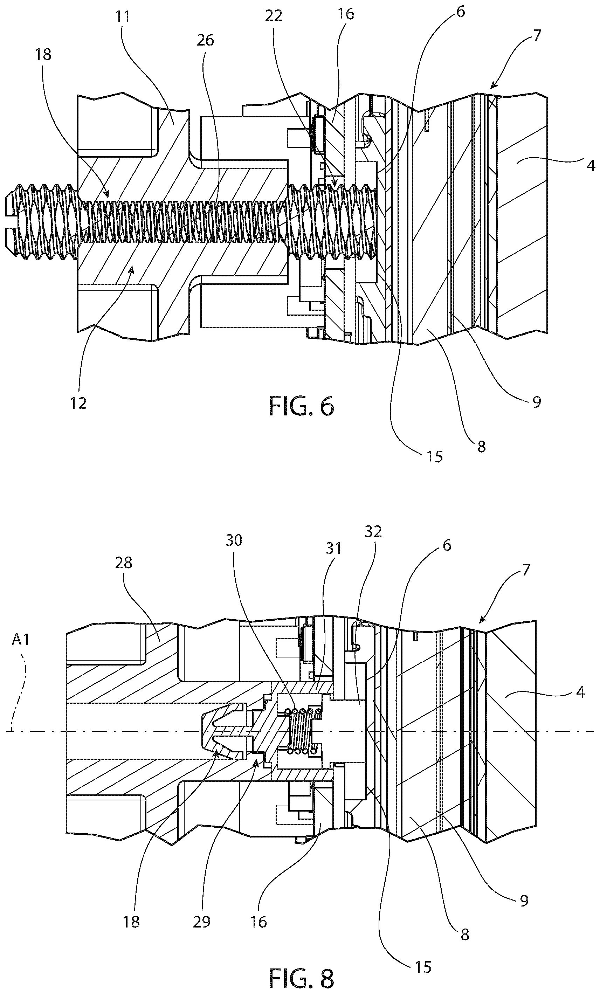

In accordance with a first embodiment and with reference to Figure 6, each push element 12 is coupled to the support element 11 so as to allow the adjustment of the thrust exerted by the push element 12 on the rear wall 6 of the housing 5.

In particular, each opening 18 of the support element 11 is a threaded through opening. Each push element 12 comprises a threaded pin 26 configured to be screwed within a respective opening 18.

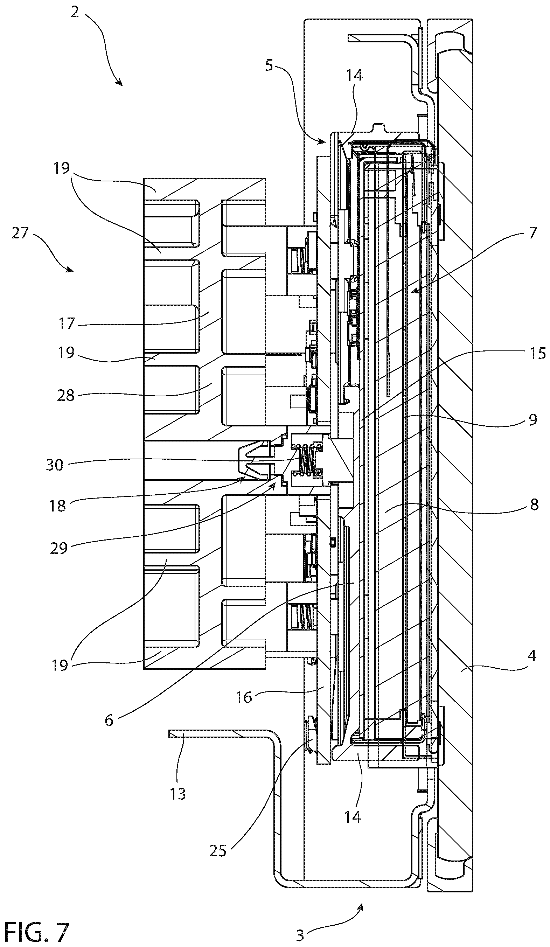

With reference to Figure 7, the user interface device 2 manufactured in accordance with a second embodiment of the present invention is shown.

In accordance with said embodiment, the user interface device 2 comprises a push assembly 27 provided with a support element 28 fixed to the frame 3 and/or to the cover screen 4 and a plurality of push elements 29, which are arranged between the support element 28 and the rear wall 6 of the housing 5 and are configured to push against the rear wall 6 so as to press the display panel 7 against the cover screen 4.

With reference to Figure 8, each push element 29 comprises an elastic body 30 configured to apply an elastic return force between the support element 28 and the rear wall 6 of the housing 5.

In particular, each push element 29 comprises a cylindrical body 31, which extends along a respective longitudinal axis A1 and is fixed to the support element 28, and a sliding body 32, which is arranged in contact with the rear wall 6 of the housing 5 and is slidingly coupled to the cylindrical body 31 along the respective longitudinal axis A1. The elastic body 30 is interposed between the cylindrical body 31 and the sliding body 32 so as to determine an elastic return force directed along the respective longitudinal axis A1.

It will be apparent that variations can be made to the present invention without thereby departing from the scope of protection of the appended claims.

## Claims

1. A user interface device for a household appliance, the user interface device (2) comprising:
- a frame (3);
- a transparent cover screen (4) fixed to the frame (3) ;
- a housing (5) provided with a rear wall (6);
- a display panel (7), which is housed in the housing (5), is arranged between the rear wall (6) and the cover screen (4), and is provided with a light source (8) configured to generate graphical images and with a touch sensor (9) configured to detect a touch or a swipe on the cover screen (4); and
- a push assembly (10; 27) provided with a support element (11; 28) fixed to the frame (3) and/or to the cover screen (4) and a plurality of push elements (12; 29), which are arranged between the support element (11; 28) and the rear wall (6) of the housing (5) and are configured to push against the rear wall (6) so as to press the display panel (7) against the cover screen (4).

2. The user interface device as claimed in claim 1, and comprising an electronic control board (16), which is in communication with the display panel (7) and is arranged between the support element (11; 28) of the push assembly (10; 27) and the rear wall (6) of the housing (5).

3. The user interface device as claimed in claim 2, wherein the electronic control board (16) is provided with a plurality of through openings (22); each push element (12; 29) extending through a respective through opening (22) of the electronic control board (16).

4. The user interface device as claimed in claim 2 or 3, wherein the electronic control board (16) comprises at least one coupling notch (24); the housing (5) comprising at least one engagement connector (25) configured to couple with the at least one coupling notch (24) so as to support the electronic control board (16).

5. The user interface device as claimed in any one of the foregoing claims, wherein the rear wall (6) of the housing (5) extends substantially parallel to the cover screen (4), at a distance from the cover screen (4).

6. The user interface device as claimed in any one of the foregoing claims, wherein the housing (5) comprises a plurality of lateral walls (14), which delimit together with the rear wall (6) a housing space for the display panel (7).

7. The user interface device as claimed in any one of the foregoing claims, wherein the rear wall (6) of the housing (5) comprises a plurality of shaped portions (15), each of which is configured to house an end portion of a respective push element (12; 29).

8. The user interface device as claimed in any one of the foregoing claims, wherein the support element (11; 28) of the push assembly (10; 27) extends substantially parallel with respect to the cover screen (4), at a distance from the rear wall (6) of the housing (5).

9. The user interface device as claimed in any one of the foregoing claims, wherein the push assembly (10; 27) comprises a plurality of connection elements (20), which couple jointly the support element (11; 28) to the frame (3) and/or to the cover screen (4), preferably said connection elements (20) being arranged at respective ends of the support element (11; 28).

10. The user interface device as claimed in any one of the foregoing claims, wherein one of the push elements (12; 29) is arranged at a central portion of the support element (11; 28).

11. The user interface device as claimed in any one of the foregoing claims, wherein each push element (12) is coupled to the support element (11) so as to allow an adjustment of the thrust exerted by the push element (12) on the rear wall (6) of the housing (5).

12. The user interface device as claimed in claim 11, wherein the support element (11) comprises a plurality of threaded openings (18); each push element (12) comprising a threaded pin (26) configured to be screwed within a respective threaded opening (18).

13. The user interface device as claimed in any one of claims 1 to 10, wherein each push element (29) comprises an elastic body (30) configured to apply an elastic return force between the support element (28) and the rear wall (6) of the housing (5).

14. The user interface device as claimed in claim 13, wherein each push element (29) comprises a cylindrical body (31), which extends along a respective longitudinal axis (A1) and is fixed to the support element (28), and a sliding body (32), which is arranged in contact with the rear wall (6) of the housing (5) and is slidingly coupled to the cylindrical body (31) along the respective longitudinal axis (A1); the elastic body (30) being interposed between the cylindrical body (31) and the sliding body (32) so as to determine an elastic return force directed along the respective longitudinal axis (A1).

15. A household appliance comprising the user interface device (2) as claimed in any one of the foregoing claims.
